# EUROPEAN PATENT APPLICATION

(11) **EP 4 459 374 A1**
(43) Date of publication of application: **06.11.2024**
(21) Application number: 22915993.4
(22) Date of filing: 26.12.2022
(51) Int. Cl.: G03F 7/004, B41C 1/00, B41N 1/00, G03F 7/00, G03F 7/095, G03F 7/20

(54) **FLEXOGRAPHIC PRINTING ORIGINAL PLATE AND METHOD FOR MANUFACTURING FLEXOGRAPHIC PRINTING PLATE**

(30) Priority: 27.12.2021 JP 2021212325; 27.07.2022 JP 2022119288
(71) Applicant: FUJIFILM Corporation, Tokyo 106-8620 (JP)
(72) Inventor: SHIRAKAWA, Masato, Haibara-gun, Shizuoka 421-0396 (JP)
(74) Representative: HGF
(86) International application number: PCT/JP2022/047812
(87) International publication number: WO 2023/127770

(57) **Abstract**

An object of the present invention is to provide a flexographic printing plate precursor which has few mask defects, is unlikely to contaminate an apparatus during development, and is capable of obtaining a flexographic printing plate having excellent concave line reproducibility and being unlikely to cause ink entanglement; and a manufacturing method of a flexographic printing plate using the flexographic printing plate precursor. The flexographic printing plate precursor of the present invention is a flexographic printing plate precursor including, at least, in the following order, a support, a photosensitive resin layer, and a heat-sensitive image forming layer, in which the heat-sensitive image forming layer contains a pigment as an infrared absorber and a dye as an ultraviolet absorber, and an optical density of the heat-sensitive image forming layer is 3.0 or more.

## Description

### BACKGROUND OF THE INVENTION

### 1. Field of the Invention

The present invention relates to a flexographic printing plate precursor and a manufacturing method of a flexographic printing plate using the same.

### 2. Description of the Related Art

A precursor of a flexographic printing plate (a flexographic printing plate precursor) generally includes a photosensitive resin layer formed of a photosensitive resin composition on a support formed of a polyester film or the like. The flexographic printing plate is manufactured by exposing a surface of the photosensitive resin layer of the precursor to a predetermined image and then removing a resin in a portion not exposed.

In a so-called analog-type flexographic printing plate precursor, a negative film on which the predetermined image is already formed is placed on the photosensitive resin layer, and the predetermined image is exposed on the surface of the photosensitive resin layer through this negative film.

On the other hand, in a laser ablation mask (LAM)-type flexographic printing plate precursor, a heat-sensitive image forming layer (infrared ablation layer) is provided in advance on the photosensitive resin layer, an infrared laser is used to draw digitized negative image information directly onto the heat-sensitive image forming layer to produce a desired negative pattern, and then the predetermined image is exposed on the surface of the photosensitive resin layer through this negative pattern (mask).

By the way, it is necessary to shield the heat-sensitive image forming layer (mask) on which a desired negative pattern has been formed from ultraviolet rays or the like in the exposure step. On the other hand, a flexographic printing plate precursor using a heat-sensitive mask layer (heat-sensitive image forming layer) having an optical density of 3.0 or more has been proposed (JP2007-139853A).

### SUMMARY OF THE INVENTION

In recent years, there has been a demand for printing more fine and clear. In this regard, there has been a demand for a flexographic printing plate precursor having a heat-sensitive image forming layer with few defects (pinholes or the like) so as not to form an unintended image. That is, a flexographic printing plate precursor having few mask defects has been required.

Under such circumstances, the present inventor has found that, in a case where the flexographic printing plate precursor is produced with reference to JP2007-139853A, relatively large pinholes may be generated in the heat-sensitive image forming layer.

In addition, in recent years, a flexographic printing plate precursor which is difficult to be contaminated during development has been required from the viewpoint of productivity and the like. In addition, further improvement in concave line reproducibility and further reduction in ink entanglement are required for a flexographic printing plate to be obtained.

In view of the above-described circumstances, an object of the present invention is to provide a flexographic printing plate precursor which has few mask defects, is unlikely to contaminate an apparatus during development, and is capable of obtaining a flexographic printing plate having excellent concave line reproducibility and being unlikely to cause ink entanglement; and a manufacturing method of a flexographic printing plate using the flexographic printing plate precursor.

As a result of intensive studies on the above-described objects, the present inventor has found that the above-described objects can be achieved by setting an optical density of a heat-sensitive image forming layer to be 3.0 or more and using a pigment as an infrared absorber and a dye as an ultraviolet absorber in combination in the heat-sensitive image forming layer, and has completed the present invention.

That is, the present inventors have found that the above-described objects can be achieved by the following configurations.
(1) A flexographic printing plate precursor comprising, at least, in the following order:
   a support;
   a photosensitive resin layer; and
   a heat-sensitive image forming layer,
   in which the heat-sensitive image forming layer contains a pigment as an infrared absorber and a dye as an ultraviolet absorber, and
   an optical density of the heat-sensitive image forming layer is 3.0 or more.
(2) The flexographic printing plate precursor according to (1),
   in which the dye is a triazine-based compound.
(3) The flexographic printing plate precursor according to (1) or (2),
   wherein the photosensitive resin layer contains a phenol-based polymerization inhibitor Q1 which is a compound represented by Formula (a) described later, and a peroxide decomposer Q2 which is a compound represented by any one of Formula (b-1), (b-2), or (b-3), or Formula (c-1) or (c-2) described later.
(4) The flexographic printing plate precursor according to (3),
   in which the phenol-based polymerization inhibitor Q1 is a compound represented by Formula (d) described later.
(5) The flexographic printing plate precursor according to any one of (1) to (4),
   in which the photosensitive resin layer contains water-dispersible particles.
(6) A manufacturing method of a flexographic printing plate having a non-image area and an image area, the manufacturing method comprising:
   a mask forming step of forming an image on the heat-sensitive image forming layer of the flexographic printing plate precursor according to any one of (1) to (5) to form a mask;
   an exposure step of, after the mask forming step, imagewise exposing the photosensitive resin layer of the flexographic printing plate precursor through the mask; and
   a development step of, after the exposure step, performing development using a developer to form the non-image area and the image area.
(7) The manufacturing method of a flexographic printing plate according to (6),
   in which the exposure step is a step of performing the exposure using an LED-UV as a light source.
(8) The manufacturing method of a flexographic printing plate according to (6) or (7),
   in which the developer is an aqueous developer.

As described below, according to the present invention, it is possible to provide a flexographic printing plate precursor which has few mask defects, is unlikely to contaminate an apparatus during development, and is capable of obtaining a flexographic printing plate having excellent concave line reproducibility and being unlikely to cause ink entanglement; and a manufacturing method of a flexographic printing plate using the flexographic printing plate precursor.

### DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the present specification, the numerical range expressed by using "to" means a range including the numerical values before and after "to" as the lower limit value and the upper limit value.

In addition, each component may be used alone or in combination of two or more thereof. Here, in a case where two or more kinds are used in combination for each component, a content with regard to the component indicates the total content thereof, unless otherwise specified.

In addition, "(meth)acryl" represents a notation of "acryl" or "methacryl", "(meth)acrylate" represents a notation of "acrylate" or "methacrylate", and "(meth)acryloyl" represents a notation of "acryloyl" or "methacryloyl".

In addition, a solid content refers to a component other than a volatile component such as a solvent.

In addition, in the present specification, with regard to the flexographic printing plate precursor, defects (pinholes or the like) of a heat-sensitive image forming layer are also referred to as "mask defects", and the fact that the defects of the heat-sensitive image forming layer are few is also referred to as "excellent in mask defect".

In addition, with regard to the flexographic printing plate precursor, the ease of contamination of the apparatus during development is also referred to as "apparatus contamination", and the difficulty of contaminating the apparatus during the development is also referred to as "excellent in apparatus contamination".

In addition, with regard to the flexographic printing plate precursor, the fact that a flexographic printing plate to be obtained has excellent highlight reproducibility is also simply referred to as "excellent in highlight reproducibility".

In addition, with regard to the flexographic printing plate precursor, the fact that a flexographic printing plate to be obtained has excellent concave line reproducibility is also simply referred to as "excellent in concave line reproducibility".

In addition, with regard to the flexographic printing plate precursor, the fact that a flexographic printing plate to be obtained is unlikely to cause ink entanglement is also simply referred to as "excellent in ink entanglement".

In addition, with regard to the flexographic printing plate precursor, the fact that the mask defects, the apparatus contamination, the highlight reproducibility, the concave line reproducibility, and the ink entanglement are excellent is also simply referred to as "effects of the present invention are excellent".

### [Flexographic printing plate precursor]

The flexographic printing plate precursor according to the embodiment of the present invention (hereinafter, also referred to as "printing plate precursor according to the embodiment of the present invention") is a flexographic printing plate precursor including, at least, in the following order, a support, a photosensitive resin layer, and a heat-sensitive image forming layer, in which the heat-sensitive image forming layer contains a pigment as an infrared absorber and a dye as an ultraviolet absorber, and an optical density of the heat-sensitive image forming layer is 3.0 or more.

In the printing plate precursor according to the embodiment of the present invention, since the optical density of the heat-sensitive image forming layer is 3.0 or more, it is considered that a mask formed from the heat-sensitive image forming layer sufficiently cuts ultraviolet rays or the like during exposure. Therefore, it is considered that a depth between halftone dots or concave line portion is reduced, and ink entanglement is suppressed from occurring, and as a result, excellent concave line reproducibility and ink entanglement are exhibited.

In addition, in the printing plate precursor according to the embodiment of the present invention, since the pigment as an infrared absorber and the dye as an ultraviolet absorber are used in combination in the heat-sensitive image forming layer, it is considered that desired toughness is ensured, mask defects are suppressed, and the mask is dispersed into fine pieces during development to suppress contamination of the apparatus.

Hereinafter, each layer of the printing plate precursor according to the embodiment of the present invention will be described.

### [Support]

A material used for the support is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.

From the viewpoint of dimensional stability and availability, the support is preferably a polymer film or cloth, and more preferably a polymer film. The morphology of the support is determined by whether the polymer layer is sheet-like or sleeve-like.

As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.

Examples of the polymer film include a film formed of various polymers such as polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; and glass fiber reinforced plastic resin (such as epoxy resin and phenolic resin). Among these, from the viewpoint of dimensional stability and the like, a polyester film is preferable.

Examples of the above-described polyester film include a PET film, a PBT film, and a PEN film, and from the viewpoint of dimensional stability and the like, a polyethylene terephthalate (PET) film is preferable.

A thickness of the support is not particularly limited, but from the viewpoint of dimensional stability and handleability, it is preferably 5 to 3,000 µm, more preferably 50 to 2,000 µm, and still more preferably 100 to 1,000 µm.

### [Photosensitive resin layer]

The photosensitive resin layer (hereinafter, also referred to as "photosensitive layer") is not particularly limited, and can be formed of a known photosensitive resin composition in the related art.

The photosensitive resin layer contains, for example, water-dispersible particles, a liquid polymer, a rubber component, a photopolymerizable monomer, a photopolymerization initiator, a plasticizer, a surfactant, and the like.

### <Water-dispersible particles>

From the reason that the effects of the present invention are more excellent, the photosensitive resin layer preferably contains water-dispersible particles.

The water-dispersible particles are not particularly limited, but from the reason that the effects of the present invention are more excellent, a polymer is preferable.

Specific examples of the above-described polymer include diene-based polymers (for example, polybutadiene, natural rubber, styrene-butadiene copolymer, acrylonitrile-butadiene copolymer, methyl methacrylate-butadiene copolymer, polychloroprene, and polyisoprene), polyurethane, vinylpyridine polymer, butyl polymer, thiokol polymer, acrylate polymer, and a polymer obtained by copolymerizing these polymers with other components such as acrylic acid and methacrylic acid. These may be used alone or in combination of two or more.

From the reason that the effects of the present invention are more excellent, the above-described polymer is preferably a diene-based polymer and more preferably polybutadiene.

From the reason that the effects of the present invention are more excellent, it is preferable that the above-described polymer does not have a reactive functional group (for example, a (meth)acryloyloxy group) at both terminals.

From the reason that the effects of the present invention are more excellent, it is preferable that the above-described polymer is a polymer obtained by removing water from water-dispersible latex. Specific examples of the above-described water-dispersible latex include water-dispersible latex of specific examples of the above-described polymer.

### (Content)

In the photosensitive resin layer, from the reason that the effects of the present invention are more excellent, a content of the water-dispersible particles is preferably 5% to 80% by mass, more preferably 10% to 50% by mass, and still more preferably 20% to 40% by mass with respect to the total solid content of the photosensitive resin layer.

### <Liquid polymer>

From the reason that the effects of the present invention are more excellent, the photosensitive resin layer preferably contains a liquid polymer.

From the reason that the effects of the present invention are more excellent, it is preferable that the liquid polymer has a reactive functional group at both terminals.

### (Main chain)

A polymer constituting a main chain of the liquid polymer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that more elastic and flexible film can be easily formed, a rubber or a thermoplastic elastomer is preferable, a rubber is more preferable, and a diene-based rubber is still more preferable.

Specific examples of the above-described rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more. Among these, from the reason that the water developability is improved, or from the viewpoint of drying properties and image reproducibility, at least one rubber selected from the group consisting of butadiene rubber (BR) and nitrile rubber (NBR) is preferable, and butadiene rubber is more preferable.

Examples of the above-described thermoplastic elastomer include a polybutadiene-based thermoplastic elastomer, a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, SBS or SIS is particularly preferable.

### (Terminal)

As described above, from the reason that the effects of the present invention are more excellent, it is preferable that the liquid polymer has a reactive functional group at both terminals.

The above-described reactive functional group is not particularly limited, but from the reason that the effects of the present invention are more excellent, an ethylenically unsaturated group is preferable.

From the reason that the effects of the present invention are more excellent, the above-described ethylenically unsaturated group is preferably a vinyl group (CH₂=CH-), an allyl group (CH₂=CH-CH₂-), a (meth)acryloyl group, or a (meth)acryloyl group, and more preferably a (meth)acryloyloxy group.

The liquid polymer may have a reactive functional group at both terminals of the polymer constituting the main chain through a divalent linking group.

The above-described divalent linking group is not particularly limited, and examples thereof include a linear, branched, or cyclic divalent aliphatic hydrocarbon group (for example, an alkylene group such as a methylene group, an ethylene group, and a propylene group), a divalent aromatic hydrocarbon group (for example, a phenylene group), -O-, -S-, -SO₂-, -NR_{L}-, -CO-, -NH-, -COO-, -CONR_{L}-, -O-CO-O-, -SO₃-, -NHCOO-, -SO₂NR_{L}-, -NH-CO-NH-, and a group in which two or more of these groups are combined (for example, an alkyleneoxy group, an alkyleneoxycarbonyl group, an alkylenecarbonyloxy group, and the like). Here, R_{L} represents a hydrogen atom or an alkyl group (preferably having 1 to 10 carbon atoms).

### (Molecular weight)

From the reason that the effects of the present invention are more excellent, a weight-average molecular weight (Mw) of the liquid polymer is preferably 1,000 or more and less than 100,000, and more preferably 5,000 to 50,000.

In the specification of the present application, the weight-average molecular weight is measured by a gel permeation chromatography method (GPC) and is obtained by converting with standard polystyrene. Specifically, for example, HLC-8220 GPC (manufactured by Tosoh Corporation) is used as GPC, three of TSKgeL SuperHZM-H, TSKgeL SuperHZ4000, and TSKgeL SuperHZ2000 (all manufactured by Tosoh Corporation, 4.6 mmID × 15 cm) are used as a column, and tetrahydrofuran (THF) is used as an eluent. In addition, as the conditions, a sample concentration of 0.35% by mass, a flow rate of 0.35 mL/minute (min), a sample injection amount of 10 µL, and a measurement temperature of 40°C are set, and an IR detector is used. In addition, a calibration curve is created using 8 samples of "F-40", "F-20", "F-4", "F-1", "A-5000", "A-2500", "A-1000", and "n-propylbenzene" which are "Standard Samples TSK standard, polystyrene" (manufactured by TOSOH Corporation).

### (Content)

In the photosensitive resin layer, from the reason that the effects of the present invention are more excellent, a content of the above-described liquid polymer is preferably 1% to 30% by mass, more preferably 3% to 20% by mass, and still more preferably 5% to 10% by mass with respect to the total solid content of the photosensitive resin layer.

### <Rubber component>

The rubber component is not particularly limited, and specific examples of the above-described rubber include butadiene rubber (BR), nitrile rubber (NBR), acrylic rubber, epichlorohydrin rubber, urethane rubber, isoprene rubber, styrene isoprene rubber, styrene butadiene rubber, ethylene-propylene copolymer, and chlorinated polyethylene. These may be used alone or in combination of two or more.

Among these, from the reason that the effects of the present invention are more excellent, the rubber component is preferably at least one rubber component selected from the group consisting of butadiene rubber (BR) and nitrile rubber (NBR), and is more preferably butadiene rubber.

The rubber component is preferably solid. In addition, the rubber component is distinguished from the above-described water-dispersible particles in that the rubber component is not a particle.

### (Molecular weight)

A weight-average molecular weight (Mw) of the rubber component is not particularly limited, but from the reason that the effects of the present invention are more excellent, it is preferably 100,000 or more, more preferably 200,000 or more, still more preferably 300,000 to 2,000,000, particularly preferably 300,000 to 1,500,000, and most preferably 300,000 to 700,000.

### (Content)

In the photosensitive resin layer, from the reason that the effects of the present invention are more excellent, a content of the rubber component is preferably 1% to 50% by mass, more preferably 5% to 40% by mass, and still more preferably 7% to 30% by mass with respect to the total solid content of the photosensitive resin layer.

### <Photopolymerizable monomer>

The photopolymerizable monomer is not particularly limited, and a photopolymerizable monomer known and used in a flexographic printing plate precursor in the related art can be used.

Examples of the photopolymerizable monomer include ethylenically unsaturated compounds.

The ethylenically unsaturated compound may be a monofunctional ethylenically unsaturated compound or a polyfunctional ethylenically unsaturated compound, but from the reason that the effects of the present invention are more excellent, a polyfunctional ethylenically unsaturated compound is preferable.

From the reason that the effects of the present invention are more excellent, suitable examples of the polyfunctional ethylenically unsaturated compound include a compound having 2 to 20 terminal ethylenically unsaturated groups, and specific examples thereof include alkanediol (meth)acrylate compounds such as 1,3-butanediol dimethacrylate, 1,4-butanediol diacrylate, 1,4-butanediol dimethacrylate, 1,6-hexanediol diacrylate, 1,6-hexanediol dimethacrylate, 1,9-nonanediol diacrylate, 1,9-nonanediol dimethacrylate, 1,12-dodecanediol diacrylate, and 1,12-dodecanediol dimethacrylate;
glycol di(meth)acrylate compounds such as ethyleneglycol di(meth)acrylate, diethyleneglycol di(meth)acrylate, triethyleneglycol di(meth)acrylate, tetraethyleneglycol di(meth)acrylate, polyethyleneglycol di(meth)acrylate, propyleneglycol di(meth)acrylate, dipropyleneglycol di(meth)acrylate, tripropyleneglycol di(meth)acrylate, tetrapropyleneglycol di(meth)acrylate, polypropyleneglycol di(meth)acrylate, ethoxylated neopentylglycol di(meth)acrylate, and propoxylated neopentylglycol di(meth)acrylate;
di- or trivinyl ether compounds such as ethyleneglycol divinyl ether, diethyleneglycol divinyl ether, triethyleneglycol divinyl ether, propyleneglycol divinyl ether, dipropyleneglycol divinyl ether, butanediol divinyl ether, hexanediol divinyl ether, cyclohexanedimethanol divinyl ether, and trimethylolpropane trivinyl ether;
di(meth)acrylate compounds of bisphenol A such as bisphenol A diglycidyl ether (meth)acrylic acid adduct, modified bisphenol A di(meth)acrylate, bisphenol A PO-adducted di(meth)acrylate, and bisphenol A EO-adducted di(meth)acrylate;
tri- or higher valent ester compounds of alcohol such as pentaerythritol tri(meth)acrylate, pentaerythritol tetra(meth)acrylate, dipentaerythritol tetra(meth)acrylate, trimethylolethane tri(meth)acrylate, trimethylolpropane tri(meth)acrylate, and tetramethylolmethane tetra(meth)acrylate; allyl compounds such as diallyl phthalate and triallyl trimellitate; and
bis(4-(meth)acryloxypolyethoxyphenyl) propane.
PO represents propylene oxide and EO represents ethylene oxide.

### (Content)

In the photosensitive resin layer, from the reason that the effects of the present invention are more excellent, a content of the photopolymerizable monomer is preferably 1% to 30% by mass, more preferably 2% to 25% by mass, and still more preferably 5% to 20% by mass with respect to the total solid content of the photosensitive resin layer.

### <Photopolymerization initiator>

The photopolymerization initiator is not particularly limited, and examples thereof include photopolymerization initiators such as alkylphenones, acetophenones, benzoin ethers, benzophenones, thioxanthones, anthraquinones, benzyls, and biacetyls.

More specific examples thereof include benzyl dimethyl ketal, 2-hydroxy-2-methyl-1-phenyl-propan-1-one, methyl-o-benzoylbenzoate, and 1-hydroxycyclohexyl phenyl ketone.

### (Content)

From the reason that the effects of the present invention are more excellent, a content of the photopolymerization initiator in the photosensitive resin layer is preferably 0.3% to 15% by mass and more preferably 0.5% to 10% by mass with respect to the total solid content of the photosensitive resin layer.

### <Plasticizer>

From the reason that the effects of the present invention are more excellent, the photosensitive resin layer preferably contains a plasticizer.

Specific examples of the plasticizer include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.

Specific examples of the oil include paraffin, naphthene, and aroma.

Specific examples of the polyester include adipic acid-based polyester.

Specific examples of the phosphoric acid-based compound include phosphoric acid ester.

### (Content)

From the reason that the effects of the present invention are more excellent, a content of the plasticizer in the photosensitive resin layer is preferably 0.1% to 40% by mass and more preferably 5% to 30% by mass with respect to the total solid content of the photosensitive resin layer.

### <Surfactant>

From the reason that the effects of the present invention are more excellent, the photosensitive resin layer preferably contains a surfactant.

Examples of the surfactant include a cationic surfactant, an anionic surfactant, and a nonionic surfactant. Among these, from the reason that the effects of the present invention are more excellent, an anionic surfactant is preferable.

Specific examples of the above-described anionic surfactant include aliphatic carboxylic acid salts such as sodium laurate and sodium oleate;
higher alcohol sulfate salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

Among these, from the reason that the effects of the present invention are more excellent, a sulfonic acid-based surfactant such as an alkyl sulfonate or an alkyl allyl sulfonate is preferable.

### (Content)

From the reason that the effects of the present invention are more excellent, a content of the surfactant in the photosensitive resin layer is preferably 0.1% to 20% by mass and more preferably 1% to 10% by mass with respect to the total solid content of the photosensitive resin layer.

### <Thermal polymerization inhibitor>

From the viewpoint of improving thermal stability during kneading, improving storage stability, and the like, the photosensitive resin layer preferably contains a thermal polymerization inhibitor (stabilizer).

Examples of the thermal polymerization inhibitor include phenols, hydroquinones, and catechols.

### (Content)

From the reason that the effects of the present invention are more excellent, a content of the thermal polymerization inhibitor in the photosensitive resin layer is preferably 0.001% to 5% by mass with respect to the total solid content of the photosensitive resin layer.

### <Other components>

To the extent that the effects of the present invention are not impaired, the photosensitive resin layer may further contain other additives such as an ultraviolet absorber, a dye, a pigment, an anti-foaming agent, and a fragrance, for the purpose of improving various properties.

### <Suitable aspect>

From the reason that the effects of the present invention are more excellent, it is preferable that the photosensitive resin layer the photosensitive resin layer contains a phenol-based polymerization inhibitor Q1 which is a compound represented by Formula (a) described later, and a peroxide decomposer Q2 which is a compound represented by any one of Formula (b-1), (b-2), or (b-3), or Formula (c-1) or (c-2) described later.

### (Phenol-based polymerization inhibitor Q1)

The phenol-based polymerization inhibitor Q1 is a compound represented by Formula (a).

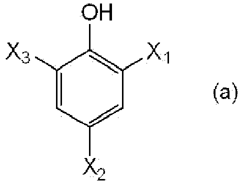

In Formula (a), X₁ to X₃ represent a hydrogen atom or a substituent (for example, a substituent W described later).

From the reason that the effects of the present invention are more excellent, the above-described substituent is preferably a hydrocarbon group or an alkoxy group (particularly, having 1 to 10 carbon atoms), which may have a substituent (for example, a substituent W described later). Specific examples of the above-described hydrocarbon group include an aliphatic hydrocarbon group, an aromatic hydrocarbon group, and a group obtained by combining these groups. The above-described aliphatic hydrocarbon group may be linear, branched, or cyclic. Specific examples of the above-described aliphatic hydrocarbon group include a linear or branched alkyl group (particularly, having 1 to 30 carbon atoms), a linear or branched alkenyl group (particularly, having 2 to 30 carbon atoms), and a linear or branched alkynyl group (particularly, having 2 to 30 carbon atoms). Examples of the above-described aromatic hydrocarbon group include an aromatic hydrocarbon group having 6 to 18 carbon atoms, such as a phenyl group, a tolyl group, a xylyl group, and a naphthyl group.

In Formula (a), from the reason that the effects of the present invention are more excellent, X₁ and X₃ are preferably a hydrogen atom or a hydrocarbon group which may have a substituent (for example, a substituent W described later). From the reason that the effects of the present invention are more excellent, the above-described hydrocarbon group is preferably an aliphatic hydrocarbon group (particularly, having 1 to 10 carbon atoms), and more preferably a branched aliphatic hydrocarbon group.

In Formula (a), from the reason that the effects of the present invention are more excellent, X₂ is preferably a substituent (for example, a substituent W described later). From the reason that the effects of the present invention are more excellent, the above-described substituent is preferably a hydrocarbon group or an alkoxy group (particularly, having 1 to 10 carbon atoms), which may have a substituent (for example, a substituent W described later). Specific examples of the hydrocarbon group are as described above. From the reason that the effects of the present invention are more excellent, the above-described hydrocarbon group is preferably an aliphatic hydrocarbon group (particularly, having 1 to 10 carbon atoms), and more preferably a linear aliphatic hydrocarbon group (particularly, an alkyl group).

From the reason that the effects of the present invention are more excellent, the phenol-based polymerization inhibitor Q1 is preferably a compound represented by Formula (d).

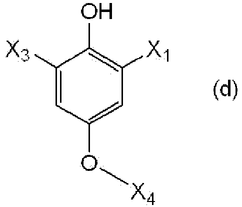

In Formula (d), X₁, X₃, and X₄ represent a hydrogen atom or a substituent (for example, a substituent W described later).

In Formula (d), suitable aspects of X₁ and X₃ are the same as in Formula (a).

In Formula (d), from the reason that the effects of the present invention are more excellent, X₄ is preferably a hydrocarbon group which may have a substituent (for example, a substituent W described later). From the reason that the effects of the present invention are more excellent, the above-described hydrocarbon group is preferably an aliphatic hydrocarbon group (particularly, having 1 to 10 carbon atoms), and more preferably a linear aliphatic hydrocarbon group (particularly, an alkyl group).

From the reason that the effects of the present invention are more excellent, a content of the phenol-based polymerization inhibitor Q1 in the photosensitive resin layer is preferably 0.01% to 2% by mass, more preferably 0.02% to 1% by mass, and still more preferably 0.05% to 0.5% by mass with respect to the total solid content of the photosensitive resin layer.

### (Peroxide decomposer Q2)

The peroxide decomposer Q2 is a compound represented by any one of Formula (b-1), (b-2), or (b-3), or Formula (c-1) or (c-2).

### (1) Formulae (b-1) to (b-3)

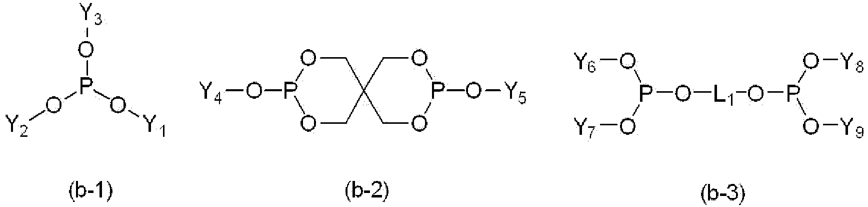

In Formulae (b-1) to (b-3), Y₁ to Y₉ represent a substituent (for example, a substituent W described later), L₁ represents a divalent linking group. Y₁ to Y₃ may be bonded to each other to form a ring through a single bond or a divalent linking group.

From the reason that the effects of the present invention are more excellent, the above-described substituent is preferably a hydrocarbon group which may have a substituent (for example, a substituent W described later). Specific examples of the hydrocarbon group are as described above.

### (1-1) Formula (b-1)

In Formula (b-1), from the reason that the effects of the present invention are more excellent, Y₁ to Y₃ are preferably an aromatic hydrocarbon group (particularly, having 6 to 18 carbon atoms), an aliphatic hydrocarbon group (particularly, having 1 to 30 carbon atoms), or a group obtained by combining these groups, which may have a substituent (for example, a substituent W described later); and more preferably an aromatic hydrocarbon group (particularly, a phenyl group) having a branched aliphatic hydrocarbon group (for example, a t-butyl group) or an aliphatic hydrocarbon group (particularly, an alkyl group). Specific examples of the aromatic hydrocarbon group and the aliphatic hydrocarbon group are as described above.

In Formula (b-1), any two of Y₁ to Y₃ may be linked to each other to form a ring. In a case where any two of Y₁ to Y₃ are linked to each other to form a ring, the two may be linked to each other through a divalent linking group. The above-described divalent linking group is not particularly limited, and examples thereof include a linear, branched, or cyclic divalent aliphatic hydrocarbon group (for example, an alkylene group such as a methylene group, an ethylene group, and a propylene group), a divalent aromatic hydrocarbon group (for example, a phenylene group), -O-, -S-, -SO₂-, -NR_{L}-, -CO-, -NH-, -COO-, -CONR_{L}-, -O-CO-O-, -SO₃-, -NHCOO-, -SO₂NR_{L}-, -NH-CO-NH-, and a group in which two or more of these groups are combined (for example, an alkyleneoxy group, an alkyleneoxycarbonyl group, an alkylenecarbonyloxy group, and the like). Here, R_{L} represents a hydrogen atom or an alkyl group (preferably having 1 to 10 carbon atoms). From the reason that the effects of the present invention are more excellent, the above-described divalent linking group is preferably an alkylene group (particularly, having 1 to 10 carbon atoms).

### (1-2) Formula (b-2)

In Formula (b-2), from the reason that the effects of the present invention are more excellent, Y₄ and Y₅ are preferably an aromatic hydrocarbon group (particularly, having 6 to 18 carbon atoms), an aliphatic hydrocarbon group (particularly, having 1 to 30 carbon atoms), or a group obtained by combining these groups, which may have a substituent (for example, a substituent W described later); and more preferably an aromatic hydrocarbon group (particularly, a phenyl group) having a branched aliphatic hydrocarbon group (for example, a t-butyl group). Specific examples of the aromatic hydrocarbon group and the aliphatic hydrocarbon group are as described above.

### (1-3) Formula (b-3)

In Formula (b-3), from the reason that the effects of the present invention are more excellent, Y₆ to Y₉ are preferably an aromatic hydrocarbon group (particularly, having 6 to 18 carbon atoms), an aliphatic hydrocarbon group (particularly, having 1 to 30 carbon atoms), or a group obtained by combining these groups, which may have a substituent (for example, a substituent W described later); and more preferably an aliphatic hydrocarbon group (particularly, an alkyl group).

In Formula (b-3), specific examples of the divalent linking group represented by L₁ are as described above.

In Formula (b-3), from the reason that the effects of the present invention are more excellent, L₁ is preferably a divalent hydrocarbon group. From the reason that the effects of the present invention are more excellent, the above-described divalent hydrocarbon group is preferably a divalent aromatic hydrocarbon group (particularly, having 6 to 18 carbon atoms), a divalent aliphatic hydrocarbon group (particularly, having 1 to 30 carbon atoms), or a group obtained by combining these groups, which may have a substituent (for example, a substituent W described later); and more preferably a group obtained by combining a divalent aromatic hydrocarbon group (particularly, an arylene group) and a divalent aliphatic hydrocarbon group (particularly, an alkylene group).

### (2) Formulae (c-1) and (c-2)

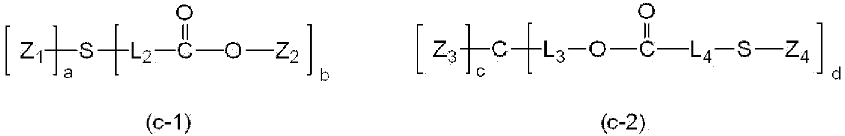

In Formula (c-1), Z₁ and Z₂ represent a substituent (for example, a substituent W described later), L₂ represents a divalent linking group, a represents 0 or 1, b represents 1 or 2, and a + b = 2 is satisfied.

In Formula (c-2), Z₃ and Z₄ represent a substituent (for example an alicyclic group W described later), L₃ represents a single bond or a divalent linking group, L₄ represents a divalent linking group, c represents an integer of 0 to 3, d represents an integer of 1 to 4, and c + d = 4 is satisfied.

In a case where b in Formula (c-1) is 2, a plurality of Z₂'s or L₂'s may be the same or different from each other.

In a case where c in Formula (c-2) is an integer of 2 or 3, a plurality of Z₃'s may be the same or different from each other.

In a case where d in Formula (c-2) is an integer of 2 to 4, a plurality of Z₄'s, Ls's, or L₄'s may be the same or different from each other.

### (2-1) Formula (c-1)

In Formula (c-1), from the reason that the effects of the present invention are more excellent, Z₁ and Z₂ are preferably a hydrocarbon group which may have a substituent (for example, a substituent W described later), more preferably an aliphatic hydrocarbon group (particularly, having 1 to 30 carbon atoms), and still more preferably an alkyl group.

In Formula (c-1), specific examples of the divalent linking group represented by L₂ are as described above.

In Formula (c-1), from the reason that the effects of the present invention are more excellent, L₂ is preferably a divalent hydrocarbon group. From the reason that the effects of the present invention are more excellent, the above-described divalent hydrocarbon group is preferably a divalent aliphatic hydrocarbon group (particularly, having 1 to 30 carbon atoms).

In Formula (c-1), from the reason that the effects of the present invention are more excellent, a is preferably 0.

In Formula (c-1), from the reason that the effects of the present invention are more excellent, b is preferably 2.

### (2-2) Formula (c-2)

A suitable aspect of Z₄ in Formula (c-2) is the same as that for Z₁ to Z₂ in Formula (c-1).

Specific examples and suitable aspects of L₃ and L₄ in Formula (c-2) are the same as those for L₂ in Formula (c-1).

In Formula (c-2), from the reason that the effects of the present invention are more excellent, c is preferably an integer of 0 to 2, more preferably an integer of 0 or 1, and still more preferably 0.

In Formula (c-2), from the reason that the effects of the present invention are more excellent, d is preferably an integer of 2 to 4, more preferably an integer of 3 or 4, and still more preferably 4.

In the photosensitive resin layer, from the reason that the effects of the present invention are more excellent, a content of the peroxide decomposer Q2 is preferably 0.01% to 5% by mass, more preferably 0.1% to 3% by mass, and still more preferably 0.5% to 2% by mass with respect to the total solid content of the photosensitive resin layer.

### <Substituent W>

The substituent W in the present specification will be described below.

Examples of the substituent W include a halogen atom, a hydrocarbon group (for example, an aliphatic hydrocarbon group such as a linear, branched, or cyclic alkyl group, an alkenyl group, and an alkynyl group; and an aromatic hydrocarbon group), an aryl group, a heterocyclic group (also referred to as a heterocyclic ring group), a cyano group, a hydroxy group, a nitro group, a carboxy group, an alkoxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, an alkyl or arylsulfonylamino group, a mercapto group, an alkylthio group, an arylthio group, a heterocyclic thio group, a sulfamoyl group, a sulfo group, an alkyl or arylsulfinyl group, an alkyl or arylsulfonyl group, an acyl group, an aryloxycarbonyl group, an alkoxycarbonyl group, a carbamoyl group, an aryl or heterocyclic azo group, an imide group, a phosphino group, a phosphinyl group, a phosphinyloxy group, a phosphinylamino group, a phosphono group, a silyl group, a hydrazino group, a ureido group, a boronic acid group (-B(OH)₂), a phosphate group (-OPO(OH)₂), a sulfate group (-OSO₃H), and other known substituents.

### <Thickness>

From the reason that the effects of the present invention are more excellent, a thickness of the photosensitive resin layer is preferably 0.2 to 6 mm, more preferably 0.5 to 3 mm, and still more preferably 1.0 to 2.0 mm.

### <Forming method of photosensitive resin layer>

A method of forming the photosensitive resin layer is not particularly limited, and examples thereof include a method of mixing the above-described respective components to prepare a composition (composition for a photosensitive resin layer), and applying the composition onto a base material or the like.

### [Heat-sensitive image forming layer]

The heat-sensitive image forming layer contains a pigment as an infrared absorber and a dye as an ultraviolet absorber. In addition, the optical density of the above-described heat-sensitive image forming layer is 3.0 or more.

The heat-sensitive image forming layer functions as an infrared ablation layer to form a mask.

### <Infrared absorbing pigment>

As described above, the heat-sensitive image forming layer contains a pigment as an infrared absorber (hereinafter, also referred to as "infrared absorbing pigment").

The infrared absorbing pigment is not particularly limited as long as it is a pigment capable of absorbing infrared rays and converting the infrared rays into heat. Here, the pigment is intended to be a substance insoluble in a solvent such as water or a solvent.

Specific examples of the infrared absorbing pigment include a black pigment (for example, carbon black, aniline black, and cyanine black), a green pigment, carbon graphite, iron powder, a crystal water-containing inorganic compound, copper sulfate, a metal oxide (for example, cobalt oxide and tungsten oxide), and a metal powder (for example, bismuth, tin, tellurium, and aluminum).

Among these, from the viewpoint of excellent dispersibility in a binder polymer, carbon black, carbon graphite, or the like is preferable.

### (Content)

From the reason that the effects of the present invention are more excellent, a content of the infrared absorbing pigment in the heat-sensitive image forming layer is preferably 10% to 75% by mass, more preferably 20% to 50% by mass, and still more preferably 30% to 40% by mass with respect to the total solid content of the heat-sensitive image forming layer. Hereinafter, the content of the infrared absorbing pigment with respect to the total solid content of the heat-sensitive image forming layer will be also simply referred to as "content of the infrared absorbing pigment".

### <Ultraviolet absorbing dye>

As described above, the heat-sensitive image forming layer contains a dye as an ultraviolet absorbing agent (hereinafter, also referred to as "ultraviolet absorbing dye").

The ultraviolet absorbing dye is not particularly limited as long as it is a dye absorbing ultraviolet rays. Here, the dye is intended to be a substance soluble in a solvent such as water or a solvent.

From the reason that the effects of the present invention are more excellent, the ultraviolet absorbing dye is preferably a dye having an absorption in a wavelength range of 300 to 400 nm.

Specific examples of the ultraviolet absorbing dye include a benzotriazole-based compound, a triazine-based compound, and a benzophenone-based compound.

In addition, specific examples thereof also include metal complexes such as phthalocyanine, naphthalocyanine, a rhodamine coloring agent, a naphthoquinone-based coloring agent, a polymethine dye, a chalcogen-based coloring agent, cyanine, merocyanine, an azo dye, a diamine-based metal complex, a dithiol-based metal complex, a phenolthiol-based metal complex, and a mercaptophenol-based metal complex.

Among these, from the reason that the effects of the present invention are more excellent, a triazine-based compound (compound having a triazine ring) is preferable.

### (Content)

From the reason that the effects of the present invention are more excellent, a content of the ultraviolet absorbing dye in the heat-sensitive image forming layer is preferably 2% to 50% by mass, more preferably 5% to 30% by mass, and still more preferably 10% to 15% by mass with respect to the total solid content of the heat-sensitive image forming layer. Hereinafter, the content of the ultraviolet absorbing dye with respect to the total solid content of the heat-sensitive image forming layer will also be simply referred to as "content of the ultraviolet absorbing dye".

### <Content of ultraviolet absorbing dye/content of infrared absorbing pigment>

From the reason that the effects of the present invention are more excellent, a proportion of the content of the ultraviolet absorbing dye to the content of the infrared absorbing pigment (content of ultraviolet absorbing dye/content of infrared absorbing pigment) in the heat-sensitive image forming layer is preferably 10% to 70% by mass, more preferably 20% to 60% by mass, still more preferably 30% to 50% by mass, and particularly preferably 35% to 45% by mass.

### <Binder polymer>

From the reason that the effects of the present invention are more excellent, the heat-sensitive image forming layer preferably contains a rubber component and a resin component as a binder polymer.

### (Rubber component)

The rubber component is not particularly limited as long as it is a rubber which does not hinder adhesiveness with the photosensitive resin layer.

Specific examples of the rubber component include butadiene rubber (BR), acrylonitrile butadiene rubber (NBR), acrylic rubber, epichlorohydrin rubber, urethane rubber, isoprene rubber (IR), styrene isoprene rubber (SIR), styrene butadiene rubber (SBR), ethylene-propylene copolymer, and chlorinated polyethylene. These may be used alone or in combination of two or more.

Among these, from the reason that adhesiveness with the adjacent photosensitive resin layer is improved, butadiene rubber (BR), acrylonitrile butadiene rubber (NBR), or styrene butadiene rubber (SBR) is preferable, and acrylonitrile butadiene rubber (NBR) is more preferable.

From the reason that the effects of the present invention are more excellent, a content of the rubber component in the heat-sensitive image forming layer is preferably 5% to 50% by mass, more preferably 10% to 40% by mass, and still more preferably 20% to 30% by mass with respect to the total solid content of the heat-sensitive image forming layer.

### (Resin component)

The resin component is not particularly limited as long as it contains at least one of an acrylic resin or a methacrylic resin (hereinafter, abbreviated as "(meth)acrylic resin").

Here, the (meth)acrylic resin is not particularly limited as long as it is a polymer or a copolymer of one or more monomers selected from acrylic acid, methacrylic acid, acrylic acid ester, and methacrylic acid ester.

From the reason that the effects of the present invention are more excellent, a content of the resin component in the heat-sensitive image forming layer is preferably 5% to 50% by mass, more preferably 10% to 40% by mass, and still more preferably 20% to 30% by mass with respect to the total solid content of the heat-sensitive image forming layer.

### <Other components>

The heat-sensitive image forming layer may contain a component (other component) other than the above-described components. Examples of such a component include a resin component other than the above-described resin component (for example, a polystyrene resin, a polyester resin, a polyamide resin, a polysulfone resin, a polyethersulfone resin, a polyimide resin, an acrylic resin, an acetal resin, an epoxy resin, a polycarbonate resin, and the like), and a plasticizer.

### <Thickness>

From the reason that the effects of the present invention are more excellent, a thickness of the heat-sensitive image forming layer is preferably 0.1 to 6 µm, more preferably 0.5 to 3 µm, and still more preferably 1.0 to 2.0 µm.

### <Optical density>

As described above, the optical density of the heat-sensitive image forming layer is 3.0 or more. Among these, from the reason that the effects of the present invention are more excellent, the optical density is preferably 3.3 or more, more preferably 3.5 or more, still more preferably 3.8 or more, particularly preferably 4.0 or more, and most preferably 4.5 or more.

The upper limit of the above-described optical density is not particularly limited, but from the reason that the effects of the present invention are more excellent, it is preferably 10.0 or less and more preferably 6.0 or less.

The above-described optical density can be measured using, for example, a transmission densitometer such as BMT-1 manufactured by SAKATA INX CORPORATION.

### <Forming method of heat-sensitive image forming layer>

A method of forming the heat-sensitive image forming layer is not particularly limited, and examples thereof include a method of mixing the above-described respective components to prepare a composition (composition for a heat-sensitive image forming layer), and applying the composition onto a base material or the like.

### [Other layers]

The printing plate precursor according to the embodiment of the present invention may include a layer (other layers) other than the above-described layers. Examples of such a layer include a cover sheet (protective film) and a functional layer.

### <Cover sheet>

The printing plate precursor according to the embodiment of the present invention preferably includes a cover sheet on a side of the heat-sensitive image forming layer opposite to the photosensitive resin layer.

The cover sheet is not particularly limited, but is preferably a transparent polymer film and may be one layer alone or two or more layers laminated.

Here, the "transparent" means that a transmittance of visible light is 60% or more, preferably 80% or more and particularly preferably 90% or more.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, a surface (surface on which the heat-sensitive image forming layer is formed) of the cover sheet may be subjected to peeling treatment for suppressing adhesion of the heat-sensitive image forming layer and enhancing peelability of the cover sheet. Examples of such a peeling treatment include a method of applying a mold release agent to the surface of the cover sheet to form a peeling layer. Examples of the mold release agent include a silicone-based peeling agent and an alkyl-based peeling agent.

A thickness of the cover sheet is preferably 25 to 250 µm.

### <Functional layer>

The printing plate precursor according to the embodiment of the present invention may include an optional functional layer between the photosensitive resin layer and the heat-sensitive image forming layer.

The above-described functional layer is not particularly limited, but for the purpose of blocking atmospheric oxygen which may cause polymerization inhibition during ultraviolet (UV) exposure and suppressing mass transfer between the heat-sensitive image forming layer and the photosensitive resin layer, it is preferable to use a water-soluble polymer. Examples of the water-soluble polymer include polyvinyl alcohols, modified polyvinyl alcohols, polyvinylpyrrolidone, water-soluble cellulose derivatives, polyethylene glycol, poly(meth)acrylonitriles, and polyamides.

In addition, the functional layer may contain an additive within a range which does not adversely affect the performance.

Examples of the above-described additive include a plasticizer and various stabilizers.

In addition, in order to reduce the above-described defects of the functional layer, an additive such as an antifoaming agent and a leveling agent may be formulated as long as it does not adversely affect the performance.

### [Manufacturing method of flexographic printing plate precursor]

A method for manufacturing the flexographic printing plate precursor according to the embodiment of the present invention is not particularly limited, and examples thereof include a method of obtaining a laminate X consisting of heat-sensitive image forming layer/cover sheet by applying the composition for a heat-sensitive image forming layer onto the cover sheet and drying the cover sheet, sandwiching the composition for a photosensitive resin layer between the laminate X and an adhesive-coated surface of a support, and then heating and pressing the laminate to manufacture a flexographic printing plate precursor in which the support, the photosensitive resin layer, the heat-sensitive image forming layer, and the cover sheet are laminated in this order.

### [Manufacturing method of flexographic printing plate]

The manufacturing method of a flexographic printing plate having a non-image area and an image area, the manufacturing method including: a mask forming step of forming an image on the heat-sensitive image forming layer of the above-described flexographic printing plate precursor according to the embodiment of the present invention to form a mask; an exposure step of, after the mask forming step, imagewise exposing the photosensitive resin layer of the flexographic printing plate precursor through the mask; and a development step of, after the exposure step, performing development using a developer to form the non-image area and the image area.

Hereinafter, the respective steps will be described.

### [Mask forming step]

The mask forming step is a step of forming an image on the heat-sensitive image forming layer to form a mask to be used in the exposure step described later.

Here, in the heat-sensitive image forming layer, in a case of being irradiated with an infrared laser, the action of the infrared absorbing pigment generates heat, which decomposes the thermally decomposable compound to remove, that is, to laser-ablate the heat-sensitive image forming layer.

Therefore, by selectively laser-ablating the heat-sensitive image forming layer based on the image data, it is possible to obtain a mask capable of forming a latent image on the photosensitive resin layer.

For the infrared laser irradiation, an infrared laser having an oscillation wavelength in a range of 750 nm to 3,000 nm is used.

Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.

In addition, a fiber laser which amplifies these light sources with a fiber can also be used.

Among these, from the reason that drawing accuracy is improved, it is preferable to use a fiber laser.

### [Exposure step]

The exposure step is a step of imagewise exposing the photosensitive resin layer through the mask obtained in the above-described mask forming step, and by imagewise irradiating the photosensitive resin layer with ultraviolet rays, crosslinking and/or polymerization of regions irradiated with the ultraviolet rays can be induced to be cured.

Examples of the light source for the exposure include a fluorescent lamp and an LED-UV (ultraviolet light source using a light emitting diode), but from the reason that the effects of the present invention are more excellent (particularly, from the reason that the highlight reproducibility is more excellent), LED-UV is preferable.

From the reason that the effects of the present invention are more excellent (particularly, from the reason that the highlight reproducibility is more excellent), an UV illuminance of the light source is preferably 50 mW/cm² or more and more preferably 100 mW/cm² or more. The upper limit of the UV illuminance of the light source is not particularly limited, but from the reason that the effects of the present invention are more excellent, it is preferably 10 W/cm² or less.

### [Development step]

The development step is a step of performing development using a developer to form a non-image area and an image area.

The developer used in the development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).

In addition, a content of water contained in the aqueous developer is preferably 80% to 99.99% by mass and more preferably 90% to 99.9% by mass with respect to the total mass of the aqueous developer.

### [Rinse step]

From the reason that the effects of the present invention are more excellent, the manufacturing method of a flexographic printing plate according to the embodiment of the present invention preferably includes a rinsing step of, after the above-described development step, rinsing surfaces of the non-image area and the image area formed in the development step with water.

As a rinsing method in the rinse step, a method of washing with tap water, a method of spraying high pressure water, a method of rubbing the surfaces of the non-image area and the image area with a brush using a known batch-type or transport-type brush-type washing machine as a developing machine for flexographic printing plates mainly in the presence of water, and the like may be used.

### [Back exposure step]

From the reason that the effects of the present invention are more excellent, the manufacturing method of a flexographic printing plate according to the embodiment of the present invention preferably includes a back exposure step of, before the above-described mask forming step or before the above-described exposure step, performing ultraviolet irradiation from the support side of the flexographic printing plate precursor.

### Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

### [Example 1]

### [Preparation of composition for photosensitive resin layer]

63.6 parts by mass of a water-dispersible latex (Nipol LX111NF, water-dispersible latex of polybutadiene, solid content: 55%, manufactured by ZEON CORPORATION), 10 parts by mass of a telechelic polymer (BAC-45, manufactured by OSAKA ORGANIC CHEMICAL INDUSTRY LTD.; polybutadiene having acryloyloxy groups at both terminals, Mw = 10,000), and 8.7 parts by mass of 1,9-nonanediol dimethacrylate (NK ESTER NOD-N, manufactured by Shin-Nakamura Chemical Co., Ltd.) were mixed with each other, and moisture was evaporated for 3 hours in a dryer heated to 60°C to obtain a mixture containing water-dispersible particles.

The mixture, 20 parts by mass of butadiene rubber (NF35R, manufactured by Asahi Kasei Co., Ltd.), 15 parts by mass of a plasticizer (Diana Process Oil PW-32, manufactured by Idemitsu Kosan Co., Ltd.), and 4.4 parts by mass of a surfactant (RAPISOL A-90, effective content: 90%, manufactured by NOF CORPORATION) were kneaded in a kneader set at 110°C for 45 minutes. Thereafter, 0.2 parts by mass of a thermal polymerization inhibitor (dibutylhydroxytoluene (BHT), compound represented by Formula (a); in Formula (a), X₁ and X₃ represent a t-butyl group, and X₂ represents a methyl group) (phenol-based polymerization inhibitor Q1) and 3 parts by mass of a photopolymerization initiator (benzyl dimethyl ketal, manufactured by Tokyo Chemical Industry Co. Ltd.) were put into the kneader, and the mixture was kneaded for 5 minutes to obtain a composition for a photosensitive resin layer.

### [Preparation of composition for heat-sensitive image forming layer]

70 parts by mass of carbon black (MA8 manufactured by Mitsubishi Chemical Corporation) as an infrared absorbing pigment, 27.6 parts by mass of 2,2',4,4'-tetrahydroxybenzophenone as an ultraviolet absorbing dye, and 3 parts by mass of a plasticizer (Diana Process Oil PW-32, manufactured by Idemitsu Kosan Co., Ltd.) were added to 100 parts by mass of a binder polymer consisting of 50 parts by mass of an acrylic resin A (Hi-pearl M5000, Tg: 65°C, manufactured by Negami Chemical Industrial Co., Ltd.) and 50 parts by mass of NBR, and 812 parts by mass of methyl isobutyl ketone as a solvent was further added thereto, the mixture was mixed by stirring with blades. The obtained mixed solution was dispersed by a three-roll mill, and methyl isobutyl ketone was further added thereto so that the solid content was 15% by mass, thereby preparing a composition for a heat-sensitive image forming layer.

### [Production of flexographic printing plate precursor]

The composition for a heat-sensitive image forming layer described above was applied onto a PET film (cover sheet) having a thickness of 125 µm, which had been coated with a silicone-based mold release agent, using a bar coater such that a thickness of the coating film after drying was 1 µm, and dried at 120°C for 5 minutes to obtain a laminate X consisting of heat-sensitive image forming layer/cover sheet.

Next, the composition for a photosensitive resin layer described above was interposed between the above-described laminate X and a surface of a support, which had been formed by coating a surface of a PET film (base material) having a thickness of 125 µm with an adhesive, and the laminate was pressed with a press machine heated to 120°C such that a thickness of the photosensitive resin layer was 1.5 mm, thereby producing a flexographic printing plate precursor of Example 1, in which the support, the photosensitive resin layer, the heat-sensitive image forming layer, and the cover sheet were laminated in this order.

### [Examples other than Example 1, and Comparative Examples]

Flexographic printing plate precursors of Examples other than Example 1 and Comparative Examples were produced by the same procedure as in Example 1, except that, in the preparation of the composition for a heat-sensitive image forming layer, the type and content of the infrared absorbing pigment and the ultraviolet absorbing dye were changed as described in the column of heat-sensitive image forming layer in Table 1; in the preparation of the composition for a photosensitive resin layer, the type and content of the phenol-based polymerization inhibitor Q1 were changed as described in the column of photosensitive resin layer in Table 1, and for Examples in which the peroxide decomposer Q2 is listed in the column of photosensitive resin layer in Table 1, a peroxide decomposer Q2 with the type and content described in the same column was added together with the phenol-based polymerization inhibitor Q1; and in the production of the flexographic printing plate precursor, the thickness of the heat-sensitive image forming layer was changed as described in the column of heat-sensitive image forming layer in Table 1. In Comparative Examples 1, 3, and 4, the ultraviolet absorbing dye was not blended in the preparation of the composition for a heat-sensitive image forming layer. In addition, in Comparative Example 2, the infrared absorbing pigment was not blended in the preparation of the composition for a heat-sensitive image forming layer.

### [Infrared absorbing pigment]

The type of the column of "Infrared absorbing pigment" in Table 1 is as follows. A pigment 1 corresponds to the above-described infrared absorbing pigment.

### · Pigment 1: carbon black (MA8 manufactured by Mitsubishi Chemical Corporation)

The content of "Infrared absorbing pigment" in Table 1 indicates % by mass with respect to the total solid content of the heat-sensitive image forming layer, that is, the total solid content of the composition for a heat-sensitive image forming layer.

### [Ultraviolet absorbing dye]

The types of the column of "Ultraviolet absorbing dye" in Table 1 are as follows. Dyes 2 to 7 all correspond to the above-described ultraviolet absorbing dye.
· Dye 2: 2,2',4,4'-tetrahydroxybenzophenone (the following structure) 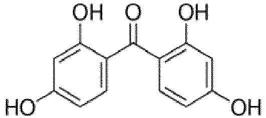
· Dye 3: Disperse Yellow 3 (the following structure) 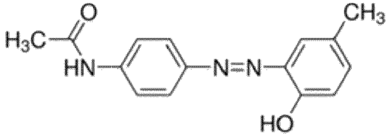
· Dye 4: curcumin (the following structure) 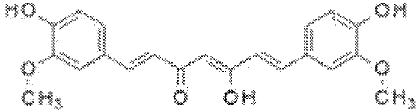
· Dye 5: Sudan Black (the following structure) 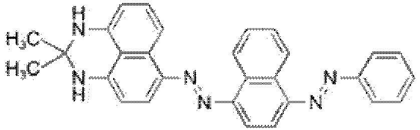
· Dye 6: Tinuvin 1600 (the following structure) 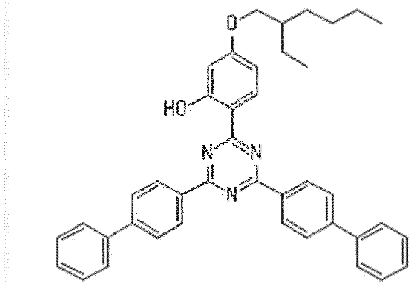
· Dye 7: ADK STAB LA-F70 (the following structure)

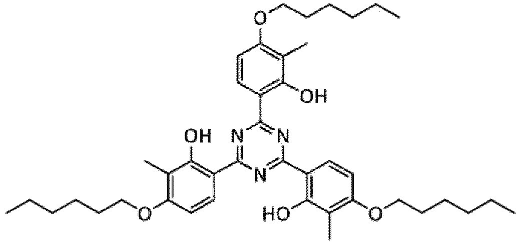

The content of "Ultraviolet absorbing dye" in Table 1 indicates % by mass with respect to the total solid content of the heat-sensitive image forming layer, that is, the total solid content of the composition for a heat-sensitive image forming layer.

### [Phenol-based polymerization inhibitor Q1]

The types of the column of "Phenol-based polymerization inhibitor Q1" in Table 1 are as follows. BHT and MEHQ both correspond to the phenol-based polymerization inhibitor Q1.
· BHT: dibutylhydroxytoluene (the following structure) (compound represented by Formula (a); in Formula (a), X₁ and X₃ represent a t-butyl group, and X₂ represents a methyl group) 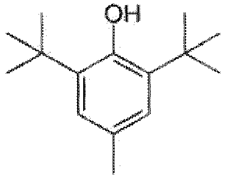
· MEHQ: p-methoxyphenol (the following structure) (compound represented by Formula (a); here, X₁ and X₃ represent a hydrogen atom, and X₂ represents a methoxy group)

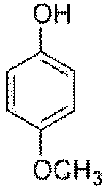

### [Peroxide decomposer Q2]

The types of the column of "Peroxide decomposer Q2" in Table 1 are as follows. Q2-1 to Q2-10 all correspond to the peroxide decomposer Q2.
· Q2-1: ADK STAB 2112 (the following structure; here, tBu represents a t-butyl group) (compound represented by Formula (b-1); here, Y₁ to Y₃ represent a 2,4-di-t-butylphenyl group) 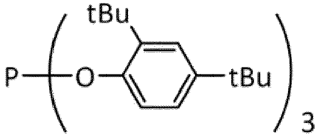
· Q2-2: ADK STAB 1178 (the following structure) (compound represented by Formula (b-1); here, Y₁ to Y₃ represent a nonyl group) 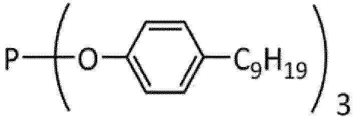
· Q2-3: ADK STAB C (the following structure) (compound represented by Formula (b-1); here, two of Y₁ to Y₃ represent a phenyl group, and one thereof represents an octyl group) 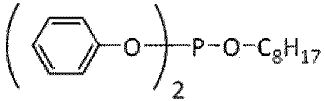
· Q2-4: ADK STAB HP-10 (the following structure; here, tBu represents a t-butyl group) (compound represented by Formula (b-1); here, two of Y₁ to Y₃ represent a 2,4-di-t-butylphenyl group, in which the two are linked to each other through a methylene group to form a ring, and one thereof represents an octyl group) 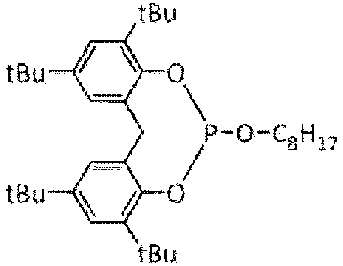
· Q2-5: ADK STAB PEP-36 (the following structure; here, tBu represents a t-butyl group) (compound represented by Formula (b-2); here, Y₄ and Y₅ represent a 2,5-di-t-butyl-4-methylphenyl group) 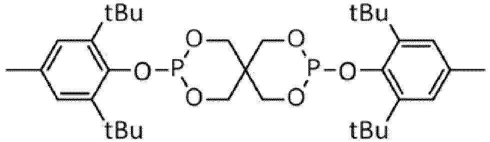
· Q2-6: ADK STAB 1500 (the following structure; here, R represents an alkyl group having 12 to 15 carbon atoms) (compound represented by Formula (b-3); here, Y₆ to Y₉ represent an alkyl group having 12 to 15 carbon atoms, and L₁ represents -C₆H₆-C(CH₃)₂-C₆H₆-) 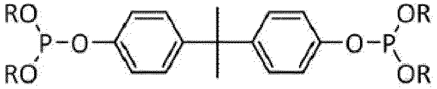
· Q2-7: didodecyl 3,3'-thiodipropionate (the following structure) (compound represented by Formula (c-1); here, Z₂ represents a dodecyl group, L₂ represents an ethylene group, a represents 0, and b represents 2) 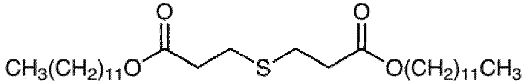
· Q2-8: dimyristyl 3,3'-thiodipropionate (the following structure) (compound represented by Formula (c-1); here, Z₂ represents a myristyl group, L₂ represents an ethylene group, a represents 0, and b represents 2) 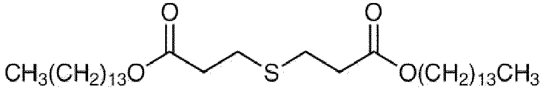
· Q2-9: distearyl 3,3'-thiodipropionate (the following structure) (compound represented by Formula (c-1); here, Z₂ represents a stearyl group, L₂ represents an ethylene group, a represents 0, and b represents 2) 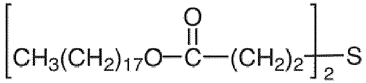
· Q2-10: pentaerythritol tetrakis[3-laurylthiopropionate] (the following structure) (compound represented by Formula (c-2); here, Z₄ represents a dodecyl group, L₃ represents a methylene group, L₄ represents an ethylene group, c represents 0, and d represents 4)

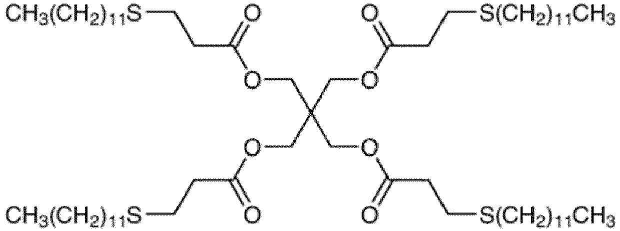

### [Optical density]

Table 1 shows the optical density of the heat-sensitive image forming layer for each example. The optical density was measured using a transmission densitometer (BMT-1 manufactured by Sakata Inx Corporation).

### [Production of flexographic printing plate]

A flexographic printing plate was produced as follows, using each of the obtained flexographic printing plate precursors.

### [Back exposure step]

Using Concept 302 EC DLF (manufactured by Glunz & Jensen) (ultraviolet exposure machine), a back surface side (support side) of the flexographic printing plate precursor was exposed (back exposure) for 18 seconds with energy of 80 W.

### [Mask forming step]

Next, the cover sheet was peeled off, and an evaluation image was formed on the heat-sensitive image forming layer by ablation using CDI Spark 2530 Inline (manufactured by Esko-Graphics BV) (imaging machine) to form a mask. The evaluation image was as follows.
· Highlight reproducibility: halftone dot image of 1 cm square, in which a halftone dot area ratio was included from 0.4% to 10% in increments of 0.4% at an image line number of 175 lpi
· Concave line reproducibility: concave line image in which a concave line width was included in a range of 20 µm to 100 µm in increments of 10 µm
· Ink entanglement: halftone dot image of 1 cm square, in which a halftone dot area ratio was included from 5% to 50% in increments of 5% at an image line number of 175 lpi

### [Exposure step]

The photosensitive resin layer was imagewise exposed (main exposure) through the formed mask.

Specifically, using CDI Spark 2530 Inline (manufactured by Esko-Graphics BV) (ultraviolet (LED-UV) exposure machine), the exposure (main exposure) was performed under the conditions of 720 seconds and 3 rotations from the surface. The UV illuminance was set to 200 mW/cm².

### [Development step]

Thereafter, development was performed with an aqueous solution (concentration: 0.5% by mass) (developer) of Finish Power & Pure Powder SP (manufactured by Reckitt Benckiser Japan Ltd.) using C-Touch 2530 (manufactured by GSTR) (developer), thereby forming a non-image area and an image area. In this way, a flexographic printing plate having a non-image area and an image area was obtained.

### [Evaluation]

The highlight reproducibility, the concave line reproducibility, the ink entanglement, the mask defects, and the apparatus contamination were evaluated as follows. The results are shown in Table 1.

The highlight reproducibility, the concave line reproducibility, and the ink entanglement were evaluated by printing evaluation. A flexographic printing machine (manufactured by TAIYO KIKAI Ltd., TLF-270) was used as a printing machine. More specifically, the obtained flexographic printing plate was attached to a plate cylinder (drum) through a cushion tape (manufactured by Lohmann), and installed in a printer. Thereafter, a kiss-touch (printing pressure at which the entire surface of the image started to be inked) was set to 0 (reference printing pressure), and from there, printing was performed at a printing speed of 150 m/min under the condition of pushing in 80 µm. A printed material used for the evaluation was sampled up to 25 km every 5 km under the above-described conditions. As the printed material, a 50 µm OPP film FOS-AQ (manufactured by FUTAMURA CHEMICAL CO.,LTD.) was used. In addition, as an ink, a solvent flexo ink XS716 (manufactured by DIC Graphics Corporation) was used.

### [Highlight reproducibility]

The obtained flexographic printing plate was used for printing, and the following were evaluated based on the minimum halftone dot area ratio reproduced on the printed matter. It is preferable that the number of points is 2.
· 2 points: halftone dots having a halftone dot area ratio of 5% or less were reproduced.
· 1 point: halftone dots having a halftone dot area ratio of 5% or less were not reproduced.

### [Concave line reproducibility]

Printing was performed using the obtained flexographic printing plate, and the printed matter was evaluated based on the finest reproduced concave line width as follows. The term "reproduction" here means that the ink was not retained in a concave line portion on the plate and is not transferred to the printed material. In practice, the number of points is preferably 3 to 5, more preferably 4 or 5, and still more preferably 5.
· 5 points: 20 µm-wide concave line was reproduced.
· 4 points: 30 µm-wide concave line was reproduced.
· 3 points: 40 µm-wide concave line was reproduced.
· 2 points: 50 µm-wide concave line was reproduced.
· 1 point: 60 µm or more-wide concave line was reproduced.

### [Ink entanglement]

Printing was performed using the obtained flexographic printing plate, and the number of halftone dots printed on the printed matter by being connected by the ink (the number of entanglements) was counted and evaluated as follows. In practice, the number of points is preferably 3 to 5, more preferably 4 or 5, and still more preferably 5.
· 5 points: number of entanglements was 10 or less.
· 4 points: number of entanglements was 11 or more and 20 or less.
· 3 points: number of entanglements was 21 or more and 40 or less.
· 2 points: number of entanglements was 41 or more and 80 or less.
· 1 point: number of entanglements was more than 80.

### [Mask defects]

The flexographic printing plate precursor was cut into a 5 cm square to prepare an evaluation plate. The evaluation plate was placed on a light table (Fuji Color LED viewer) and irradiated with a backlight to examine the presence or absence of pinholes in the heat-sensitive image forming layer. The obtained film was evaluated as follows based on the diameter of the largest pinhole. In practice, the number of points is preferably 3 to 5, more preferably 4 or 5, and still more preferably 5.
· 5 points: 300 µm or less
· 4 points: more than 300 µm and 400 µm or less
· 3 points: more than 400 µm and 500 µm or less
· 2 points: more than 500 µm and 700 µm or less
· 1 point: larger than 700 µm

### [Apparatus contamination]

In a case where the flexographic printing plate was produced using the obtained flexographic printing plate precursor as described above, the obtained flexographic printing plate precursor was evaluated as follows depending on the amount of the heat-sensitive image forming layer adhering to tips of a development brush after development. In practice, the number of points is preferably 2 or 3, and more preferably 3.
· 3 points: heat-sensitive image forming layer was not adhered to the tips of the development brush.
· 2 points: heat-sensitive image forming layer adhered to the tips of the development brush, but was not re-adhered to the plate material to be developed next.
· 1 point: heat-sensitive image forming layer was adhered to the tips of the development brush so as to be entangled, and then re-adhered to the plate material to be developed next.

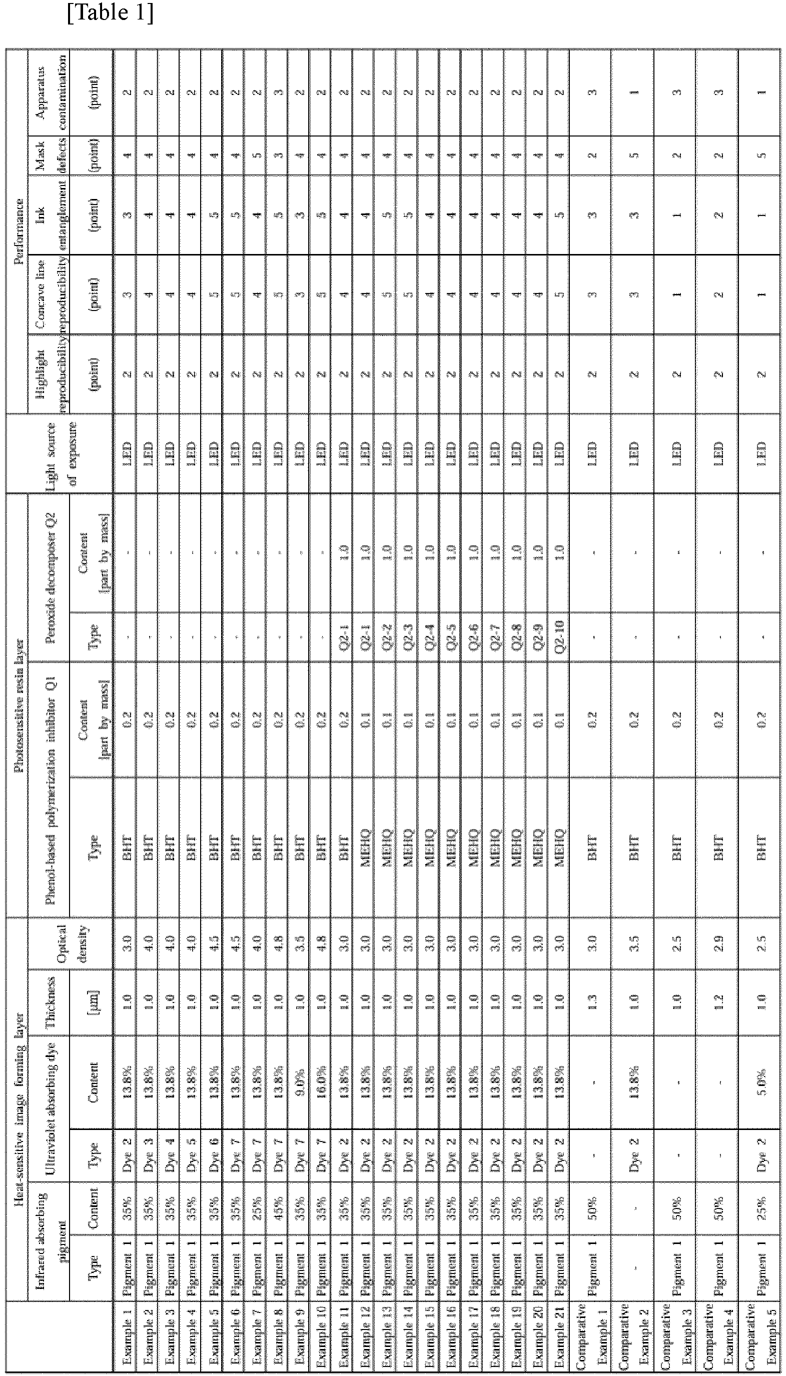

As shown in Table 1, the flexographic printing plate precursors of Examples 1 to 21, in which the heat-sensitive image forming layer contained the infrared absorbing pigment and the ultraviolet absorbing dye, and the optical density thereof was 3.0 or more, exhibited excellent concave line reproducibility, ink entanglement, mask defects, and apparatus contamination.

From the comparison between Examples 1 to 6 (comparison between aspects in which only the type of the ultraviolet absorbing dye in the heat-sensitive image forming layer was different), Examples 2 to 6 in which the optical density of the heat-sensitive image forming layer was 3.5 or more exhibited more excellent concave line reproducibility and ink entanglement. Among these, Examples 5 and 6 in which the ultraviolet absorbing dye was a triazine-based compound exhibited more excellent concave line reproducibility and ink entanglement.

In addition, from the comparison between Examples 6 to 8 (comparison between aspects in which only the content of the infrared absorbing pigment in the heat-sensitive image forming layer was different), Examples 6 and 8 in which the content of the infrared absorbing pigment in the heat-sensitive image forming layer was 30% by mass or more exhibited more excellent concave line reproducibility and ink entanglement.

In addition, from the comparison between Examples 6 to 8 (comparison between aspects in which only the content of the infrared absorbing pigment in the heat-sensitive image forming layer was different), Examples 6 and 7 in which the content of the infrared absorbing pigment in the heat-sensitive image forming layer was 40% by mass or less exhibited more excellent mask defects.

In addition, from the comparison between Examples 6, 9, and 10 (comparison between aspects in which only the content of the ultraviolet absorbing dye in the heat-sensitive image forming layer was different), Examples 6 and 10 in which the content of the ultraviolet absorbing dye in the heat-sensitive image forming layer was 10% by mass or more exhibited more excellent concave line reproducibility and ink entanglement.

In addition, from the comparison between Example 1 and Example 11 (comparison between aspects in which only the presence or absence of the peroxide decomposer Q2 in the photosensitive resin layer was different), Example 11 in which the photosensitive resin layer contained the peroxide decomposer Q2 in addition to the phenol-based polymerization inhibitor Q1 exhibited more excellent concave line reproducibility and ink entanglement.

On the other hand, in Comparative Examples 1, 3, and 4 in which the heat-sensitive image forming layer did not contain the ultraviolet absorbing dye, the mask defects were insufficient. Among these, in Comparative Examples 3 and 4 in which the optical density of the heat-sensitive image forming layer was less than 3.0, the concave line reproducibility and the ink entanglement were also insufficient. In addition, in Comparative Example 2 in which the heat-sensitive image forming layer did not contain the infrared absorbing pigment, the apparatus contamination was insufficient. In addition, in Comparative Example 5 in which, although the heat-sensitive image forming layer contained the infrared absorbing pigment and the ultraviolet absorbing dye, the optical density of the heat-sensitive image forming layer was less than 3.0, the concave line reproducibility and the ink entanglement were insufficient.

## Claims

1. A flexographic printing plate precursor comprising, at least, in the following order:
a support;
a photosensitive resin layer; and
a heat-sensitive image forming layer,
wherein the heat-sensitive image forming layer contains a pigment as an infrared absorber and a dye as an ultraviolet absorber, and
an optical density of the heat-sensitive image forming layer is 3.0 or more.

2. The flexographic printing plate precursor according to claim 1,
wherein the dye is a triazine-based compound.

3. The flexographic printing plate precursor according to claim 1 or 2,
wherein the photosensitive resin layer contains a phenol-based polymerization inhibitor Q1 which is a compound represented by Formula (a) and a peroxide decomposer Q2 which is a compound represented by any one of Formula (b-1), (b-2), or (b-3), or Formula (c-1) or (c-2), 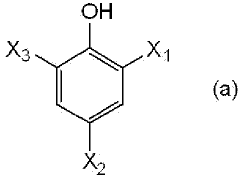
in Formula (a), X₁ to X₃ represent a hydrogen atom or a substituent, 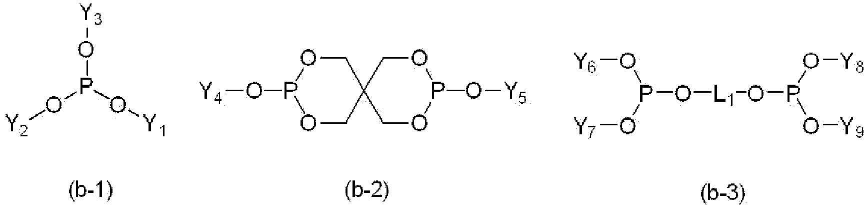
in Formulae (b-1) to (b-3), Y₁ to Y₉ represent a substituent, L₁ represents a divalent linking group, and any two of Y₁ to Y₃ may be linked to each other to form a ring, 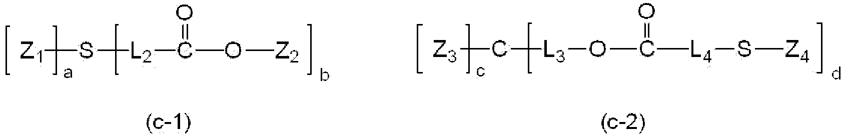
in Formula (c-1), Z₁ and Z₂ represent a substituent, L₂ represents a divalent linking group, a represents 0 or 1, b represents 1 or 2, and a + b = 2 is satisfied,
in Formula (c-2), Z₃ and Z₄ represent a substituent, L₃ represents a single bond or a divalent linking group, L₄ represents a divalent linking group, c represents an integer of 0 to 3, d represents an integer of 1 to 4, and c + d = 4 is satisfied.

4. The flexographic printing plate precursor according to claim 3,
wherein the phenol-based polymerization inhibitor Q1 is a compound represented by Formula (d), 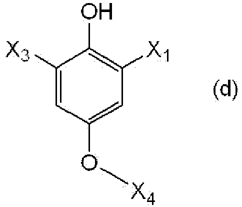
in Formula (d), X₁, X₃, and X₄ represent a hydrogen atom or a substituent.

5. The flexographic printing plate precursor according to claim 1 or 2,
wherein the photosensitive resin layer contains water-dispersible particles.

6. A manufacturing method of a flexographic printing plate having a non-image area and an image area, the manufacturing method comprising:
a mask forming step of forming an image on the heat-sensitive image forming layer of the flexographic printing plate precursor according to claim 1 or 2 to form a mask;
an exposure step of, after the mask forming step, imagewise exposing the photosensitive resin layer of the flexographic printing plate precursor through the mask; and
a development step of, after the exposure step, performing development using a developer to form the non-image area and the image area.

7. The manufacturing method of a flexographic printing plate according to claim 6,
wherein the exposure step is a step of performing the exposure using an LED-UV as a light source.

8. The manufacturing method of a flexographic printing plate according to claim 6,
wherein the developer is an aqueous developer.
